# EUROPÄISCHE PATENTSCHRIFT

(11) **EP 3 347 991 B1**
(45) Veröffentlichungstag und Bekanntmachung des Hinweises auf die Patenterteilung: **18.09.2019**
(21) Anmeldenummer: 16777991.7
(22) Anmeldetag: 05.10.2016
(51) Int. Cl.: H04B 1/10, H03H 9/46, H04B 1/00, H03M 1/12, H04L 27/26

(54) **EMPFÄNGER MIT MINDESTENS ZWEI EMPFANGSPFADEN ZUR DIGITALISIERUNG DARIN AUSGEFILTERTER SUBBÄNDER**
RECEIVER HAVING AT LEAST TWO RECEPTION PATHS FOR THE DIGITIZATION OF SUB-BANDS FILTERED OUT THEREIN
RÉCEPTEUR COMPORTANT AU MOINS DEUX VOIES DE RÉCEPTION POUR NUMÉRISATION DE SOUS-BANDES FILTRÉES

(30) Priorität: 12.10.2015 DE 102015219739
(43) Veröffentlichungstag der Anmeldung: 18.07.2018
(73) Patentinhaber: Innovationszentrum für Telekommunikationstechnik GmbH IZT, 91058 Erlangen (DE)
(72) Erfinder: PERTHOLD, Rainer, 91085 Weisendorf (DE)
(74) Vertreter: Pfitzner, Hannes
(86) Internationale Anmeldenummer: PCT/EP2016/073798
(87) Internationale Veröffentlichungsnummer: WO 2017/063931

(56) Entgegenhaltungen:
- EP-A1- 2 403 145
- US-A- 5 392 044
- US-A1- 2007 110 198
- US-A1- 2011 053 538

## Beschreibung

Ausführungsbeispiele der vorliegenden Erfindung beziehen sich auf einen Empfänger zum Empfangen eines analogen Signals wie z. B. eines Hochfrequenzsignals mit einem zu digitalisierenden Frequenzband.

Ein solcher Empfänger kann beispielsweise als Funkempfänger oder Messempfänger eingesetzt werden, insbesondere wenn über eine relativ hohe Bandbreite Funk- oder Messsignale in hoher Qualität erfasst werden sollen. In einem Frequenzbereich mit einer großen Frequenzbreite, z. B. im Frequenzbereich unter 30 MHz, können insbesondere bei großen Empfangsantennen je nach Ausbreitungsbedingungen hohe Leistungen am Antennenausgang auftreten. Dies macht typischerweise eine Begrenzung der Bandbreite am Eingang des Empfängers erforderlich. Weiterhin können sich sogenannte Intermodulationsprodukte unterschiedlicher Ordnung bilden. Hierbei sind insbesondere die Intermodulationsprodukte zweiter Ordnung kritisch.

Entsprechend dem Stand der Technik gibt es bereits einige Ansätze, z. B. unter Verwendung von Filterstufen am Eingang des Funkempfängers. Dies wird als Vorselektion bezeichnet und verfolgt das Ziel, Fehlempfang, z. B. auf der sogenannten Spiegelfrequenz, zu verhindern oder die einfallende Leistung zu begrenzen. Dieser Ansatz wird sowohl bei klassisch analogen Empfangsarchitekturen, wie z. B. Superheterodyn-Empfängern als auch für Empfänger mit Digitalisierung der Zwischenfrequenzen eingesetzt.

Weiterer Stand der Technik für Hochfrequenzempfänger ist in den Patentanmeldungen US 2011/0053538 A1, US 5.392.044 A, US 2007/0110198 A1 und EP 2 403 145 A1 bekannt.

Bei hochqualitativen Empfängern wählt man die relative Bandbreite des Vorselektrionsfilters möglichst kleiner als 1:2. Dies wird als sogenanntes Suboktavfilter-Kriterium bezeichnet. Durch derartige Suboktavfilter ist es möglich, Intermodulationsprodukte zweiter Ordnung zu reduzieren, die sich in nachfolgenden Stufen bilden können.

Insbesondere bei niedrigen Empfangsfrequenzen (z. B. Kurzwellen mit bis zu 30 MHz) und digitalen Empfängern ist damit die Vorselektion deutlich schmäler als die Echtzeitbandbreite, die aus Sicht des eingesetzten nachfolgenden Analog/Digital-Umsetzers möglich wäre. Dadurch wird die Nutzbarkeit des Empfängers erheblich eingeschränkt.

Ein Stand der Technik-Ansatz hierbei ist es, den Vorselektionsfilter entweder entsprechend der gewünschten Empfangsfrequenzen umzuschalten oder die Bandbreite der Filter den Empfangsbedingungen anzupassen. Die Umschaltung ist beispielsweise in der Patentschrift EP 2 377 249 B1 anhand eines Funksignalempfängers erläutert. Ferner zeigt die EP 2 191 579 B1 eine Vorrichtung und ein Verfahren zum Empfang eines informationssignals mit einem Informationssignalspektrum, bei denen die Bandbreite der Filter entsprechend Empfangsbedingungen angepasst werden. Durch diese Anpassung bzw. insbesondere bei Bandbreiten größer 1:2 gehen allerdings die Vorteile hinsichtlich Intermodulationsprodukte zweiter Ordnung verloren, so dass nur eine Reduktion der Signalenergie erreicht wird. Deshalb besteht der Bedarf nach verbessertem Ansatz.

Aufgabe der vorliegenden Erfindung ist es, ein Konzept zu schaffen, das den Empfang sowie die Digitalisierung eines analogen Signals, umfassend ein zu digitalisierenden Frequenzband mit einer großen Bandbreite, unter Vermeidung bzw. Reduktion von Intermodulationsprodukten (z.B. zweiter Ordnung) ermöglicht.

Diese Aufgabe wird durch die unabhängigen Patentansprüche gelöst.

Ausführungsbeispiele der vorliegenden Erfindung schaffen einen Empfänger zum Empfangen eines analogen Signals mit einem zu digitalisierenden Frequenzband. Der Empfänger umfasst eine Filtereinheit für mindestens zwei Empfangspfade, je Empfangspfad einen Analog-Digital-Wandler sowie eine digitale Signalverarbeitung. Die Filtereinheit weist mindestens zwei Filter für die mindestens zwei Empfangspfade auf, die mit einer gemeinsamen Signalquelle, wie z. B. einer Antenne, gekoppelt sind, um das analoge Signal mit dem zu digitalisierenden Frequenzband zu erhalten. Die Filter sind ausgebildet, um das zu digitalisierende Frequenzband in mindestens zwei Subbänder für die mindestens zwei Empfangspfade aufzuteilen. Die Analog-Digital-Wandler der mindestens zwei Empfangspfade sind ausgebildet, die Signale der mindestens zwei Subbänder zu digitalisieren. Die digitalisierten Signale werden nun in der digitalen Signalverarbeitung zusammengeführt. Hierzu ist die digitale Signaiverarbeitung mit den mindestens zwei Analog-Digital-Wandlern gekoppelt, um die mindestens zwei digitalisierten Signale zu erhalten, und ausgebildet für das Zusammenfügen der Signale im digitalen Bereich. Des Weiteren sind die mindestens zwei Filter im Hinblick auf ihre Filtercharakteristik derart ausgewählt, dass die mindestens zwei Subfrequenzbänder eine relative Bandbreite von < 1:2 aufweisen. Hierbei kommen bevorzugt sogenannte Suboktavfilter oder Filter mit einer sogenannten suboktaven Filtercharakteristik zum Einsatz.

Ausführungsbeispiele der vorliegenden Erfindung liegt also die Erkenntnis zugrunde, dass durch die Wahl eines ausreichend schmalen Filters bzw. einer Mehrzahl von ausreichend schmalen Filtern, weiche zu einer Filtereinheit angeordnet sind, am Empfängereingang Intermodulationsprodukte (insbesondere zweiter Ordnung) wirksam reduziert werden können. Zur Nutzung dieses Effekts für die gesamte Filterbreite werden nun die einzelnen schmalbandigen Filter zu einer Filtereinheit bzw. zu zwei Filterbänke derart zusammengeschaltet, dass die Mehrzahl der Filter möglichst das gesamte zu digitalisierende Frequenzband abdeckt. Dadurch dass jeder Filter direkt mit einem AD-Wandler gekoppelt ist, erfolgt die Digitalisierung je Subfrequenzband, so dass nachfolgend in einer digitalen Signalverarbeitungsstufe die einzelnen Subbänder verlustfrei wieder zu einem Gesamtsignal zusammengesetzt werden können. In der Konsequenz werden erstens sehr gute IP2-Werte erreicht, die die resultierenden Intermodulationsprodukte zweiter Ordnung bewerten. Zweitens sind die Signalverluste minimal, da insbesondere beim Zusammenfügen keine Verluste auftreten.

Entsprechend weiteren Ausführungsbeispielen werden als Filter sogenannte Suboktavfilter bzw. Filter mit einer suboktaven Filtercharakteristik eingesetzt. Filter mit einer suboktaven Filtercharakteristik sind insbesondere dadurch definiert, dass sie dem sogenannten Suboktavkriterium, nämlich mit einer relativen Bandbreite von < 1:2 entsprechen. Diese suboktave Filtercharakteristik hat besondere Vorteile hinsichtlich der Intermodulationsprodukte, die später noch erläutert werden.

Entsprechend bevorzugten Ausführungsbeispielen weist die Filtereinheit mehr als zwei, also beispielsweise drei oder noch mehr Filter für drei oder noch mehr Empfangspfade auf. Hierbei können sich die direkt nebeneinander angeordneten Subfrequenzbänder teilweise überlappen, wobei sich bevorzugte Subfrequenzbänder mit einem Subfrequenzband dazwischen eben nicht überlappen. Dies wird entsprechend Ausführungsbeispielen dadurch realisiert, dass die Mehrzahl der Filter zu zwei parallel geschalteten Filterbänken gruppiert sind, wobei zwei Filter in einer der zwei Filterbänke mit direkt aufeinander folgenden Mittenfrequenzen im Hinblick auf die Bandbreite so ausgelegt sind, dass sich die resultierenden Subbänder der ersten der zwei Filterbänke nicht überlappen, wobei ein Filtern der zweiten der zwei Filterbänke im Hinblick auf seine Mittenfrequenz dazwischenliegt und bzgl. Bandbreite überlappend zu den zwei Filtern der ersten Filterbank ausgelegt ist.

Ausgehend von einer beispielhaften, aber auch bevorzugten Ausführungsform, dass die relative Filterbandbreitenveränderung (also Veränderung der Filterbandbreite bezogen auf die Bandbreite des benachbarten Filters) für die drei oder mehr Filter der zwei Filterbänke in etwa (d.h. +/- 30%) gleich sind, sind die Filter beispielsweise wie folgt auszulegen. Die relative Bandbreite der Filter liegt im Bereich von 1,4 bis 1,6, wobei die Mittenfrequenzen um einen Faktor aus dem Bereich von 1,2 bis 1,4 ansteigen.

Entsprechend weiteren Ausführungsbeispielen kann die Filtereinheit auch einen Tiefpassfilter aufweisen, der im Vergleich zu den mindestens zwei Filtern die niedrigste Mittenfrequenz umfasst.

Hierbei sei angemerkt, dass entsprechend Ausführungsformen die Filter als rein passive Elemente ausgelegt sind. Hierbei können entsprechenden Ausführungsbeispielen die Mehrzahl der Filter bzw. die zwei Filterbänke über einen gemeinsamen Leistungsteiler mit der Signalquelle, wie z. B. der Antenne oder allgemein einem Eingang, verbunden sein. Derartige Filterbände lassen sich mit geringen Einführungsdämpfungen und reaktiven Leistungsteilern (Dämpfungsfaktor < 3 dB) realisieren. Hierbei ist es vorteilhaft, dass auf aktive Elemente vor den Filtern beispielsweise komplett verzichtet werden kann. Ebenso können elektronische Schalter entfallen. Durch diese Maßnahmen sind die IP2-Werte weiter zu verbessern. Ein weiterer Vorteil ist auch, dass der Sensor durch das passive Filternetzwerk gut gegen Überspannungen geschützt ist. Hierbei sei auch angemerkt, dass die passiven Filter für die Filtereinheit die Komplexität derselben sehr gering halten, insbesondere im Vergleich mit einer schaltbaren oder einer mitlaufenden Vorselektion.

Jeder Empfangspfad kann optional mit einem Verstärker und/oder einer automatischen Verstärkerregelung ausgestattet sein. Hierbei sind dann der Verstärker und/oder der Verstärker in Kombination mit der automatischen Verstärkerregelung zwischen Filter des Empfangspfads und dem zugehörigen AD-Wandler angeordnet.

Entsprechend weiteren Ausführungsbeispielen kann die digitale Signalverarbeitung als FPGA ausgeführt sein, die dann alle digitalen Signale der einzelnen Signalpfade zusammenfügt. Dieser kann zusätzlich zu dem digitalen, verlustlosen Zusammenfügen auch optional Pegelanpassungen für die einzelnen Subbänder vornehmen.

Weitere Ausführungsbeispiele schaffen ein Verfahren zum Empfangen von einem analogen Signal mit einem zu digitalisierenden Frequenzband. Das Verfahren umfasst die Schritte Aufteilen des zu digitalisierenden Frequenzbands in mindestens zwei Subbänder, des Digitalisierens je Empfangspfad der Signale der mindestens zwei Subbänder und des Zusammenfügens der mindestens zwei digitalisierten Signale. Die Filter zum Aufteilen sind, wie oben erläutert, gewählt.

Weiterbildungen sind in den Unteransprüchen definiert. Ausführungsbeispiele der vorliegenden Erfindung werden nachfolgend anhand der beiliegenden Figuren erläutert. Es zeigen:
- Fig. 1: ein Blockschaltbild eines Empfängers mit zwei Signalpfaden gemäß einem Basisausführungsbeispiel;
- Fig. 2a: ein Blockschaltbild eines Empfängers mit einer Vielzahl an Empfangspfaden, die über zwei Filterbänke zusammengeschaltet sind, gemäß einem erweiterten Ausführungsbeispiel; und
- Fig. 2b: eine Tabelle mit exemplarischen Werten zur Dimensionierung der entsprechenden Ausführungsbeispiele zur Anwendung kommenden Filterbänke.

Bevor nachfolgend Ausführungsbeispiele der vorliegenden Erfindung anhand der beiliegenden Figuren erläutert werden, sei darauf hingewiesen, dass gleiche Elemente und Strukturen mit gleichen Bezugszeichen versehen sind, so dass die Beschreibung derer aufeinander anwendbar bzw. austauschbar ist.

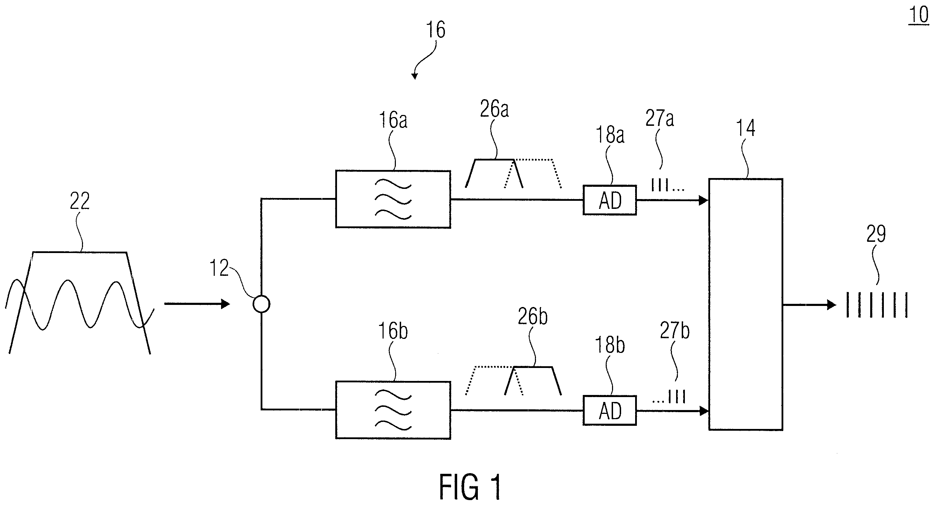

Fig. 1 zeigt einen Empfänger 10, wie z.B. eine Funkempfänger, mit einem gemeinsamen Eingang 12, einer digitalen Signalverarbeitung 14, die hier den Ausgang des Empfängers 10 darstellt. Zwischen dem Eingang 12, der beispielsweise eine Antenne oder allgemein ein Signaleingang sein kann bzw. mit einer Antenne gekoppelt sein kann, und der digitalen Signalverarbeitung 14 sind in dieser Ausführungsform zwei Signalpfade, gekennzeichnet mit den Buchstaben a und b, vorgesehen.

Jeder Signalpfad a und b umfasst einen Filter 16a bzw. 16b, wie z. B. einen analogen Filter 16a bzw. 16b sowie einen Analog-Digital-Wandler 18a und 18b. Die Filter 16a und 16b bilden zusammen die Filtereinheit 16. Alle Filter 16a und 16b der Filtereinheit 16 sind mit dem gemeinsamen Eingang 12 bzw. dem gemeinsamen Knotenpunkt 12 verbunden.

Hierdurch bekommt jeder Signalpfad a und b von dem gemeinsamen Knotenpunkt 12 dasselbe Signal 22 mit dem vollen Frequenzband. Das eingangsseitig anliegende Signal ist ein analoges Signal mit einem zu digitalisierenden Frequenzband 22. Durch die Filter 16a und 16b bzw. durch die Filtereinheit 16 wird dieses zu digitalisierende Frequenzband 22 in die Subfrequenzbänder 26a und 26b am Ausgang der Filter 16a und 16b aufgeteilt. Infolgedessen erhalten die Analog-Digital-Wandler 18a und 18b nicht mehr das volle zu digitalisierende Frequenzband 22, sondern nur noch die einzelnen Subfrequenzbänder 26a bzw. 26b. Jedes dieser Teilbänder 26a und 26b wird dann mittels des eigenen AD-Umsetzers 18a und 18b digitalisiert (vgl. Signal 27a und 27b).

In der nachfolgenden digitalen Signalverarbeitung 14 lassen sich die Teilbänder 26a und 26b wieder lückenlos zusammenfügen. Das Verfahren zum Zusammenfügen ist Stand der Technik und beispielsweise in der EP 2 377 249 B1 oder der EP 2 191 579 B1 beschrieben. Das (digitale) kombinierte Signal 29, das das gesamte zu digitalisierende Signalband umfasst, wird dann in der kombinierten Form an eine weitere Einheit (nicht dargestellt) weitergeleitet. Die Auswertung der Daten braucht keinerlei Rücksicht auf die Filtergrenzen zu nehmen, da die Frequenzbänder vorher in den Signalverarbeitungen lückenlos aneinander gefügt wurden. Hierzu kann ein herkömmliches Netzwerk oder auch ein optisches Netz, wie anhand des Pfeiles am Ausgang der digitalen Signalverarbeitung 14 illustriert ist, genutzt werden.

Hierbei erfolgt die Filterung durch die Filtereinheit 16 so, dass die Subfrequenzbänder 26a und 26b eine relative Bandbreite von < 1:2 aufweisen, also dem Suboktavfilterkriterium entsprechen. Hintergrund hierzu ist, dass Intermodulationsprodukte dann entstehen, wenn zumindest zwei Frequenzbänder in einem System parallel verarbeitet werden, wobei es zu nicht linearen Übertragungsfunktionen kommt. Wenn zwei unterschiedliche Frequenzen, hier beispielsweise die zumindest zwei Mittenfrequenzen, durch den Empfänger geleitet werden, kommt es zu den Intermodulationsprodukten zweiter Ordnung:
f₁ + f₂ und f₁ - f₂.

Um nun zu verhindern, dass sich die Intermodulationsprodukte aufsummieren, wählt man die entsprechenden Filterbandbreiten recht schmal, wobei recht schmal immer in Bezug zu setzen ist mit der Mittenfrequenz des jeweiligen Subbands. Es hat sich gezeigt, dass eine relative Filterbandbreite entsprechend der Suboktavcharakteristik, also kleiner einem Verhältnis von 1:2 beispielsweise 1:1,5 oder 1:1,35 geeignet ist, um Eingangssignale außerhalb des interessierenden Frequenzbereichs so abzuschwächen, dass deren Intermodulationsprodukte zweiter Ordnung innerhalb des Durchlassbandes sich in gleichem Maß reduzieren. Beispielsweise erfüllt eine relative Filterbandbreite von 1,6 bzw. allgemein einen Bereich von 1,4 bis 1,6 oder 1,2 bis 1,8 dieses Suboktavkriterium. Die Mittenfrequenzen jedes Filters wachsen von Filter zu Filter der Filtereinheit 16. Allgemein wird die relative Bandbreite kleiner als 1:2 gewählt, während die Mittenfrequenzen entsprechend absolut ansteigen.

Nachfolgend wird ausgehend von diesen Basisausführungsbeispielen mit den zwei Empfangspfaden a und b ein Ausführungsbeispiel mit insgesamt 12 Empfangspfaden gezeigt.

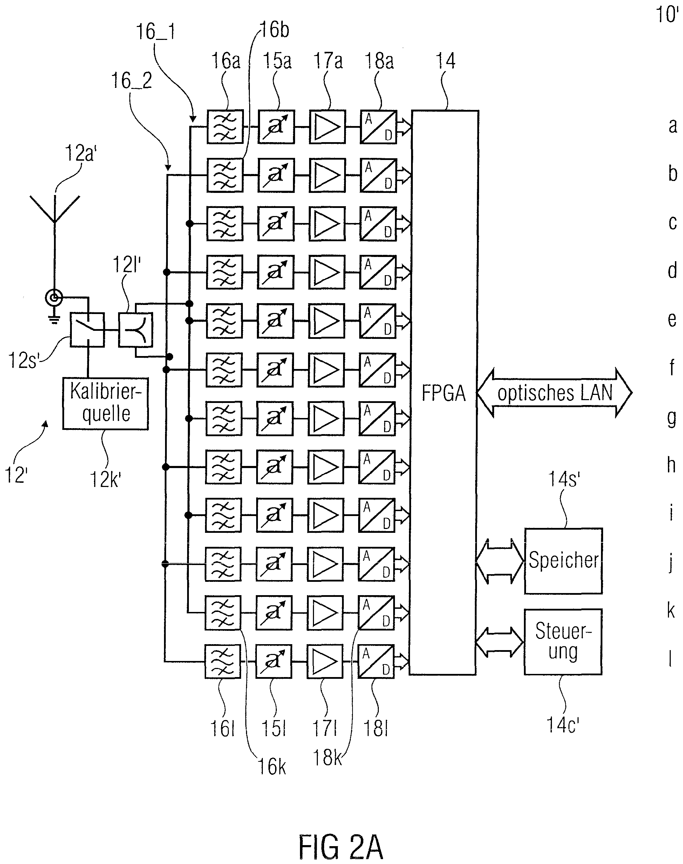

Fig. 2a zeigt den Empfänger 10' mit einem Eingang 12' und einer digitalen Signalverarbeitungsstufe 14. Zwischen dem Eingang 12' und der digitalen Signalverarbeitungsstufe 14 sind insgesamt 12 Signalpfade A bis L vorgesehen.

Die 12 Signalpfade a bis I des Empfängers 10' umfassen jeweils die Filter 16a bis 16l der Filterstufe 16 sowie die Analog-Digital-Wandler 18a bis 18l. In diesem Ausführungsbeispiel sind zwischen den Filtern 16a bis 16l und den Analog-Digital-Wandlern 18a bis 18l jeweils Verstärkerelemente 17a bis 17l eingangsseitig zum Analog-Digital-Umsetzer 18a bis 18l vorgesehen. Diese dienen dazu, das Signal in den jeweiligen Subbändern, auszugeben von den jeweiligen Filtern 16a bis 16l, in Bezug auf die Amplitude anzupassen, so dass eine wirksame Analog-Digital-Wandlung durch die Analog-Digital-Wandler 18a bis 18l erfolgen kann. Um hier die Aussteuerung der jeweiligen Verstärkerelemente 17a bis 17l effizient zu regeln, kann entsprechend weiteren Ausführungsbeispielen auch noch eine automatische Verstärkerregelung 15a bis 15l den jeweiligen Verstärkern 17a bis 17l vorgeschaltet sein.

Eingangsseitig sind die Filter 16a bis 16l der Filterstufe 16 (Filtereinheit) alle mit einem Knotenpunkt, der hier durch einen Leistungsteiler 12l' realisiert ist, miteinander verbunden. Dieser Leistungsteiler 121' ist mit seinem Eingang mit der Antenne 12a' gekoppelt. Von einer anderen Seite betrachtet heißt das also, dass der Leistungsteiler 121' zwischen dem Antenneneingang und der Filtereinheit 16, die, wie hier dargestellt, aus mehreren Filterbänken bestehen kann, geschaltet ist. Der Leistungsteiler 121' stellt eine ausreichende isoiation (z. B. 20 dB oder mehr) zwischen den Ports für die unterschiedlichen Filterbänke 16_1 und 16_2, auf weiche nachfolgend eingegangen werden wird, sicher. Hintergrund hierzu ist, dass die unterschiedlichen Filterbänke 16_1 und 16_2 sich nicht gegenseitig beeinflussen sollen.

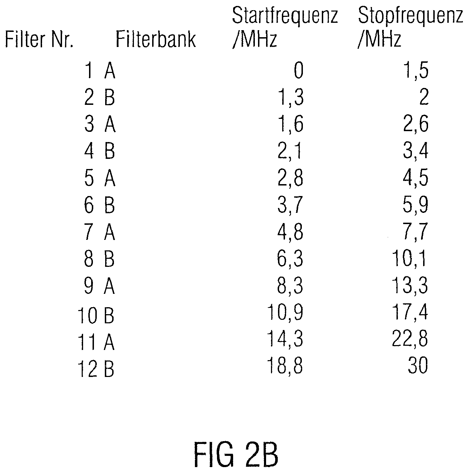

Wie bereits angedeutet, umfasst ausgangsseitig entsprechend Ausführungsbeispielen (wie auch hier dargestellt), der Leistungsteiler 121' zwei Ausgänge (Ports), wobei in einem ersten Ausgang die Filter 16a, 16c, 16e, 16g, 16i und 16k (erste Filterbank 16_1) angekoppelt werden, wobei die Filter 16b, 16d, 16f, 16h, 16j und 16l (zweite Filterbank 16_2) über den zweiten Ausgang des Leistungsteilers 12t' versorgt werden. Hintergrund hierzu ist, dass entsprechend bevorzugten Ausführungsbeispielen die Filtereinheit 16 in zwei unterschiedliche Filterbänke 16_1 und 16_2 untergliedert ist, wobei die Durchlasscharakteristik der jeweils zweiten Filter 16a, 16c, 16e, 16g, 16i und 16k, also die Filter der ersten Filterbank 16_1 sowie der Filter 16b, 16d, 16f, 16h, 16j und 16l, also die Filter der zweiten Filterbank 16_2, sich gegenseitig nicht überlappen, während die direkt aneinander angrenzenden Durchlasscharakteristika der Filter, welche eben zu den zwei unterschiedlichen Filterbänken 16_1 und 16_2 gehören, wie beispielsweise 16ab oder 16bc oder 16cd, usw. überlappend angeordnet sind, wie nachfolgend anhand der Tabelle aus Fig. 2b noch diskutiert werden wird. Dadurch, dass sich die Filter 16a, 16c, 16e, 16g, 16i und 16k bzw. die Filter 16b, 16d, 16f, 16h, 16j, 16l einer Filterbank 16_1 oder 16_2 (also die Filter 1/3/5/7/9/11 bzw. 2/4/6/8/10/12 aus Fig. 2b) nicht überlappen, wird ermöglicht, dass die Filter 16a bis 16l eingangsseitig rein reaktiv mit geringen Verlusten gekoppelt werden. Entsprechend Ausführungsbeispielen kann der Eingang des Leistungsteilers 121' bzw. der gemeinsame Knotenpunkt der Filterbank 16 über einen Schalter 12s' mit der Antenne 12a' in schaltbarer Weise gekoppelt sein, wobei an einem zweiten Eingang des Schalters 12s' eine Kalibrierquelle 12k' vorgesehen ist. Dies hat den Hintergrund, dass über die Kalibrierquelle mit einem bekannten Testsignal die Pfade a bis I und auch die digitale Signalverarbeitung 14 kalibriert werden können. Bevorzugt aber nicht zwingend erfolgt die ausgehend von der Kalibrierung ermittelte Anpassung in der digitalen Signalverarbeitung 14.

Die digitale Signalverarbeitung 14, welche beispielsweise als FPGA (oder alternativ als ASIC oder in Software) realisiert sein kann, ist dazu ausgebildet, wie bereits oben erläutert, die Ausgangssignale der Analog-Digital-Wandler 18a-18l zu kombinieren und optionaler Weise bauteilbedingte Unterschiede, welche mittels der Kalibrierquelle 12k' ermittelt wurden, auszugleichen. Diese Unterschiede können beispielsweise in einem zusätzlichen Speicher 14s' für die Kalibrierdaten hinterlegt werden. Entsprechend Ausführungsbeispielen kann die digitale Signalverarbeitung 14 dazu ausgebildet sein, die durch die automatische Verstärkerregelung (vgl. Bezugszeichen 15a bis 15l bzw. 17a bis 17l) verursachten Pegelunterschiede auszugleichen. Entsprechend weiteren Ausführungsbeispielen wird der FPGA über eine Steuerung 14c' programmiert bzw. gesteuert.

Entsprechend Ausführungsbeispielen wird also mittels oben erläuterten Empfängern 10' der gesamte gewünschte Empfangsbereich über die Signalpfade a bis I empfangen, wobei der gesamte Empfangsbereich, z. B. 0 bis 30 MHz, in die 12 Filter unterteilt werden. Bei dem Beispiel eines Empfangsbereichs von 0 bis 30 MHz bzw. allgemein von 0 bis x MHz kann entsprechenden Ausführungsbeispielen der erste Filter, hier der Filter 16a nicht als Suboktavfilter ausgeführt sein (gehört somit nicht zu der oben definierten Filterbank 16), sondern als Tiefpassfilter. Auf die Dimensionierung der weiteren 11 Filter bzw. allgemein auf die Dimensionierung der 12 Filter wird nachfolgend anhand von Fig. 2b eingegangen.

Fig. 2b zeigt eine mögliche Dimensionierung einer Filtereinheit für einen Frequenzbereich für 0 bis 30 MHz, wobei je Filter (vgl. Filter Nr. 1 bis 12) die Start- und Stoppfrequenz angegeben ist. Des Weiteren ist illustriert, zu welcher Filterbank die jeweiligen Filter 1 bis 12 gehören. Wie oben bereits erläutert, ist Filter Nr. 1 als Tiefpassfilter ausgeführt. Alle anderen Filter haben eine relative Bandbreite von Welle 1,6 zueinander. Das Suboktavkriterium ist damit außer bei Filterband Nr. 1 gut erfüllt. Da die Frequenzgrenzen von Filter zu Filter jeweils nur um den Faktor Welle 1,31 ansteigen, entsteht eine ausreichende Überlappung benachbarter Filter, also der Filter der unterschiedlichen Filterbänke (vgl. ab).

Auch wenn bei obigen Ausführungsbeispielen im einfachsten Fall von zwei Filtern, wobei also eine Filterbank durch einen Filter gebildet wurde, oder von 12 Filtern, wobei je sechs Filter zu einer Filterbank gehören, ausgegangen wurde, sei darauf hingewiesen, dass die Anzahl entsprechend der gewünschten zu digitalisierenden Frequenzbreite variieren kann. So sind also Filtereinheiten mit insgesamt acht Filtern oder auch mit insgesamt 14 Filtern oder ungerade Filteranzahlen denkbar.

Auch für obige Ausführungsbeispiele insbesondere im Zusammenhang mit einer Vorrichtung bzw. dem Empfänger 10, 10' erläutert wurden, sei darauf hingewiesen, dass weitere Ausführungsbeispiele sich auf ein entsprechendes Verfahren beziehen. Das Verfahren umfasst die Schritte:
- Aufteilen des zu digitalisierenden Frequenzbands in mindestens zwei Subbänder mittels einer Filtereinheit mit mindestens zwei Filtern für mindestens zwei Empfangspfade, wobei die mindestens zwei Filter mit einer gemeinsamen Signalquelle gekoppelt sind, um das analoge Signal mit dem zu digitalisierenden Frequenzband zu erhalten.
- Digitalisieren je Empfangspfad der Signale der mindestens zwei Subbänder mittels eines Analog-Digital-Wandlers je Empfangspfad.
- Zusammenfügen der mindestens zwei digitalisierten Signale mittels einer digitalen Signalverarbeitung, die mit den mindestens zwei Analog-Digital-Wandlern der mindestens zwei Empfangspfade gekoppelt ist, um die mindestens zwei digitalisierten Signale zu erhalten.

Die Filter sind entsprechend den obigen Dimensionierungsvorschriften ausgelegt.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar. Einige oder alle der Verfahrensschritte können durch einen Hardware-Apparat (oder unter Verwendung eines Hardware-Apparats), wie zum Beispiel einen Mikroprozessor, einen programmierbaren Computer oder eine elektronische Schaltung ausgeführt werden. Bei einigen Ausführungsbeispielen können einige oder mehrere der wichtigsten Verfahrensschritte durch einen solchen Apparat ausgeführt werden.

Je nach bestimmten Implementierungsanforderungen können Ausführungsbeispiele der Erfindung in Hardware oder in Software implementiert sein. Die Implementierung kann unter Verwendung eines digitalen Speichermediums, beispielsweise einer Floppy-Disk, einer DVD, einer Blu-ray Disc, einer CD, eines ROM, eines PROM, eines EPROM, eines EEPROM oder eines FLASH-Speichers, einer Festplatte oder eines anderen magnetischen oder optischen Speichers durchgeführt werden, auf dem elektronisch lesbare Steuersignale gespeichert sind, die mit einem programmierbaren Computersystem derart zusammenwirken können oder zusammenwirken, dass das jeweilige Verfahren durchgeführt wird. Deshalb kann das digitale Speichermedium computerlesbar sein.

Manche Ausführungsbeispiele gemäß der Erfindung umfassen also einen Datenträger, der elektronisch lesbare Steuersignale aufweist, die in der Lage sind, mit einem programmierbaren Computersystem derart zusammenzuwirken, dass eines der hierin beschriebenen Verfahren durchgeführt wird.

Allgemein können Ausführungsbeispiele der vorliegenden Erfindung als Computerprogrammprodukt mit einem Programmcode implementiert sein, wobei der Programmcode dahin gehend wirksam ist, eines der Verfahren durchzuführen, wenn das Computerprogrammprodukt auf einem Computer abläuft. Bandbreiten in der Gegend von 30MHz lassen sich heute durchaus auf leistungsfähigen PCs in Echtzeit "schritthaltend" verarbeiten.

Der Programmcode kann beispielsweise auch auf einem maschinenlesbaren Träger gespeichert sein.

Andere Ausführungsbeispiele umfassen das Computerprogramm zum Durchführen eines der hierin beschriebenen Verfahren, wobei das Computerprogramm auf einem maschinen-lesbaren Träger gespeichert ist.

Mit anderen Worten ist ein Ausführungsbeispiel des erfindungsgemäßen Verfahrens somit ein Computerprogramm, das einen Programmcode zum Durchführen eines der hierin beschriebenen Verfahren aufweist, wenn das Computerprogramm auf einem Computer abläuft.

Ein weiteres Ausführungsbeispiel der erfindungsgemäßen Verfahren ist somit ein Datenträger (oder ein digitales Speichermedium oder ein computeriesbares Medium), auf dem das Computerprogramm zum Durchführen eines der hierin beschriebenen Verfahren aufgezeichnet ist.

Ein weiteres Ausführungsbeispiel des erfindungsgemäßen Verfahrens ist somit ein Datenstrom oder eine Sequenz von Signalen, der bzw. die das Computerprogramm zum Durchführen eines der hierin beschriebenen Verfahren darstellt bzw. darstellen. Der Datenstrom oder die Sequenz von Signalen kann bzw. können beispielsweise dahin gehend konfiguriert sein, über eine Datenkommunikationsverbindung, beispielsweise über das Internet, transferiert zu werden.

Ein weiteres Ausführungsbeispiel umfasst eine Verarbeitungseinrichtung, beispielsweise einen Computer oder ein programmierbares Logikbauelement, die dahin gehend konfiguriert oder angepasst ist, eines der hierin beschriebenen Verfahren durchzuführen.

Ein weiteres Ausführungsbeispiel umfasst einen Computer, auf dem das Computerprogramm zum Durchführen eines der hierin beschriebenen Verfahren installiert ist.

Ein weiteres Ausführungsbeispiel gemäß der Erfindung umfasst eine Vorrichtung oder ein System, die bzw. das ausgelegt ist, um ein Computerprogramm zur Durchführung zumindest eines der hierin beschriebenen Verfahren zu einem Empfänger zu übertragen. Die Übertragung kann beispielsweise elektronisch oder optisch erfolgen. Der Empfänger kann beispielsweise ein Computer, ein Mobilgerät, ein Speichergerät oder eine ähnliche Vorrichtung sein. Die Vorrichtung oder das System kann beispielsweise einen Datei-Server zur Übertragung des Computerprogramms zu dem Empfänger umfassen.

Bei manchen Ausführungsbeispielen kann ein programmierbares Logikbauelement (beispielsweise ein feldprogrammierbares Gatterarray, ein FPGA) dazu verwendet werden, manche oder alle Funktionalitäten der hierin beschriebenen Verfahren durchzuführen. Bei manchen Ausführungsbeispielen kann ein feldprogrammierbares Gatterarray mit einem Mikroprozessor zusammenwirken, um eines der hierin beschriebenen Verfahren durchzuführen. Allgemein werden die Verfahren bei einigen Ausführungsbeispielen seitens einer beliebigen Hardwarevorrichtung durchgeführt. Diese kann eine universell einsetzbare Hardware wie ein Computerprozessor (CPU) sein oder für das Verfahren spezifische Hardware, wie beispielsweise ein ASIC.

Die oben beschriebenen Ausführungsbeispiele stelien lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Empfänger (10, 10') zum Empfangen eines analogen Signals mit einem zu digitalisierenden Frequenzband , mit folgenden Merkmalen:
einer Filtereinheit (16) mit mindestens zwei Filtern (16a, 16b, 16b-16l) für mindestens zwei Empfangspfade (a, b, a-l), die mit einer gemeinsamen Signalquelle (12, 12') gekoppelt sind, um das analoge Signal mit dem zu digitalisierenden Frequenzband (22) zu erhalten, und die ausgebildet ist, um das zu digitalisierende Frequenzband in mindestens zwei Subbänder (26a, 26b) (26a, 26b) für die mindestens zwei Empfangspfade (a, b, a-l) aufzuteilen;
je Empfangspfad (a, b, a-l) einen Analog-Digital-Wandler (18a, 18b, 18a-18l), die ausgebildet sind, die Signale der mindestens zwei Subbänder (26a, 26b) zu digitalisieren; und
einer digitalen Signalverarbeitung (14), die mit den mindestens zwei Analog-Digital-Wandlern (18a, 18b, 18a-18l) der mindestens zwei Empfangspfade (a, b, a-l) gekoppelt ist, um die mindestens zwei digitalisierten Signale zu erhalten, und die ausgebildet ist, um die mindestens zwei digitalisierten Signale zusammenzufügen;
**dadurch gekennzeichnet, dass** die mindestens zwei Filter (16a, 16b, 16b-16l) im Hinblick auf ihre Filtercharakteristik so ausgelegt sind, dass die mindestens zwei Subbänder (26a, 26b) eine relative Bandbreite von kleiner 1:2 zueinander aufweisen, sodass die zwei Filter (16b, 16b-16l) mit einer Veränderung der Filterbandbreite bezogen auf die Bandbreite eines benachbarten Filters der mindestens zwei Filter (16a, 16b, 16b-16l) ausgelegt sind.

2. Empfänger (10, 10') gemäß Anspruch 1, wobei die mindestens zwei Filter (16a, 16b, 16b-16l) Suboktavfilter (16a, 16b, 16b-16l) sind und/oder eine suboktave Filtercharakteristik haben.

3. Empfänger (10, 10') gemäß Anspruch 1 oder 2, wobei die Filtereinheit (16) zwei Filterbänke (16_1, 16_2) mit mindestens je einem Filter (16a, 16b, 16b-16l) umfasst, wobei die mindestens zwei Filter (16a, 16b, 16b-16l) der zwei Filterbänke (16_1, 16_2) das zu digitalisierende Frequenzband in die mindestens zwei Subbänder (26a, 26b) so aufteilen, dass sich die Subbänder (26a, 26b) der mindestens zwei Filter (16a, 16b, 16b-16l) der zwei Filterbänke (16_1, 16_2) teilweise überlappen.

4. Empfänger (10, 10') gemäß einem der vorherigen Ansprüche, wobei die Filtereinheit (16) insgesamt mindestens drei Filter (16a, 16b, 16b-16l) für mindestens drei Empfangspfade (a, b, a-l) aufweist, so dass das zu digitalisierende Frequenzband in mindestens drei Subbänder (26a, 26b) für die mindestens drei Empfangspfade (a, b, a-l) aufteilbar ist.

5. Empfänger (10, 10') gemäß Anspruch 4, wobei die mindestens drei Filter (16a, 16b, 16b-16l) eine derartige Filtercharakteristik aufweisen, dass deren Filterbandbreitenveränderung mit +/- 30% gleich ist, wobei die Mittenfrequenz der jeweiligen Bandbreite über die mindestens drei Filter (16b, 16b-16l) der Filterbank ansteigt.

6. Empfänger (10, 10') gemäß einem der Ansprüche 3 bis 5, wobei zwei Filter (16a, 16b, 16b-16l) in einem der zwei Filterbänke (16_1, 16_2) mit direkt aufeinander folgenden Mittenfrequenzen im Hinblick auf die Bandbreite so ausgelegt sind, dass sich die Subbänder (26a, 26b) der einen der zwei Filterbänke (16_1, 16_2) nicht überlappen, wobei ein Filter (16a, 16b, 16b-16l) der anderen der zwei Filterbänke (16_1, 16_2) im Hinblick auf seine Mittenfrequenz dazwischenliegt.

7. Empfänger (10, 10') gemäß einem der vorhergehenden Ansprüche, wobei die relative Bandbreite im Bereich von 1:1,4 bis 1:1,6 liegt und wobei die Mittenfrequenz um einen Faktor aus dem Bereich von 1,2 bis 1,4 ansteigt.

8. Empfänger (10, 10') gemäß einem der vorhergehenden Ansprüche, wobei die Filtereinheit (16) einen zusätzlichen Tiefpassfilter aufweist, der im Vergleich zu den mindestens zwei Filtern (16b, 16b-16l) die niedrigste Mittenfrequenz umfasst.

9. Empfänger (10, 10') gemäß einem der vorhergehenden Ansprüche, wobei die mindestens zwei Filter (16a, 16b, 16b-16l) der Filtereinheit (16) ausschließlich passive Elemente aufweisen.

10. Empfänger (10, 10') gemäß einem der vorhergehenden Ansprüche, wobei die mindestens zwei Filter (16a, 16b, 16b-16l) der Filtereinheit (16) und/oder die zwei Filterbänke (16_1, 16_2) über einen gemeinsamen Leistungsteiler (121') mit der gemeinsamen Signalquelle (12, 12a') verbunden sind.

11. Empfänger (10, 10') gemäß einem der vorhergehenden Ansprüche, wobei die mindestens zwei Filter (16a, 16b, 16b-16l) der Filtereinheit (16) und/oder der zwei Filterbänke (16_1, 16_2) mit einer gemeinsamen Antenne (12a') als gemeinsamer Signalquelle (12, 12a') verbunden sind oder über einen gemeinsamen Leistungsteiler (121') mit der gemeinsamen Antenne (12a') verbunden sind.

12. Empfänger (10, 10') gemäß einem der Ansprüche 2 bis 11, wobei die Anzahl der Filter (16a, 16b, 16b-16l) der Filtereinheit (16) so gewählt ist, dass durch die Subbänder (26a, 26b) das gesamte zu digitalisierenden Frequenzband abgedeckt wird.

13. Empfänger (10, 10') gemäß einem der vorhergehenden Ansprüche, wobei die digitale Signalverarbeitung einen FPGA umfasst.

14. Empfänger (10, 10') gemäß einem der vorhergehenden Ansprüche, wobei das Zusammenfügen in der digitalen Signalverarbeitung (14) verlustfrei erfolgt.

15. Empfänger (10, 10') gemäß einem der vorhergehenden Ansprüche, wobei jeder der mindestens zwei Signalpfade zwischen dem Analog-Digital-Wandler (18a, 18b, 18a-18l) und dem zugehörigen Filter (16a, 16b, 16b-16l) eine automatische Verstärkerregelung (15a-15l) und/oder einen Verstärker (17a-17l) aufweist.

16. Verfahren zum Empfangen von einem analogen Signal mit einem zu digitalisierenden Frequenzband , mit folgenden Schritten:
Aufteilen des zu digitalisierenden Frequenzbands in mindestens zwei Subbänder (26a, 26b) mittels einer Filtereinheit (16) mit mindestens zwei Filtern (16a, 16b, 16b-16l) für mindestens zwei Empfangspfade (a, b, a-l), wobei die mindestens zwei Filter (16a, 16b, 16b-16l) mit einer gemeinsamen Signalquelle (12, 12') gekoppelt sind, um das analoge Signal mit dem zu digitalisierenden Frequenzband zu erhalten;
Digitalisieren je Empfangspfad (a, b, a-l) der Signale der mindestens zwei Subbänder (26a, 26b) mittels eines Analog-Digital-Wandlers (18a, 18b, 18a-18l)je Empfangspfad (a, b, a-l); und
Zusammenfügen der mindestens zwei digitalisierten Signale mittels einer digitalen Signalverarbeitung (14), die mit den mindestens zwei Analog-Digital-Wandlern(18a, 18b, 18a-18l) der mindestens zwei Empfangspfade (a, b, a-l) gekoppelt ist, um die mindestens zwei digitalisierten Signale zu erhalten,
**dadurch gekennzeichnet, dass** die mindestens zwei Filter (16a, 16b, 16b-16l) hinsichtlich ihrer Filtercharakteristik so ausgelegt sind, dass die Subbänder (26a, 26b) eine relative Bandbreite von kleiner 1:2 zueinander aufweisen, sodass die zwei Filter (16a, 16b, 16b-16l) mit einer Veränderung der Filterbandbreite bezogen auf die Bandbreite eines benachbarten Filters der mindestens zwei Filter (16a, 16b, 16b-16l) ausgelegt sind.

17. Computerprogramm mit einem Programmcode zur Durchführung des Verfahrens nach Anspruch 16, wenn das Programm auf einem Computer abläuft.

## Claims

1. A receiver (10, 10') for receiving an analog signal comprising a frequency band to be digitalized, comprising:
a filter unit (16) comprising at least two filters (16a, 16b, 16b-16l) for at least two receive paths (a, b, a-l) coupled to a common signal source (12, 12') in order to obtain the analog signal comprising the frequency band (22) to be digitalized, and configured to divide the frequency band to be digitalized into at least two subbands (26a, 26b) (26a, 26b) for the at least two receive paths (a, b, a-l);
an analog-to-digital converter (18a, 18b, 18a-18l) per receive path (a, b, a-l), configured to digitalize the signals of the at least two sub-bands (26a, 26b); and
digital signal processing (14) coupled to the at least two analog-to-digital converters (18a, 18b, 18a-18l) of the at least two receive paths (a, b, a-l) to obtain the at least two digitalized signals, and configured to merge the at least two digitalized signals;
**characterized in that** the at least two filters (16a, 16b, 16b-16l), with regard to their filter characteristic, are implemented such that the at least two sub-bands (26a, 26b) comprise a relative bandwidth of smaller than 1:2 with respect to each other so that the two filters (16b, 16b-16i) are implemented with a change in filter bandwidth relative to the bandwidth of a neighboring filter of the at least two filters (16a, 16b, 16b-16l).

2. The receiver (10, 10') in accordance with claim 1, wherein the at least two filters (16a, 16b, 16b-16l) are sub-octave filters (16a, 16b, 16b-16l) and/or comprise a sub-octave filter characteristic.

3. The receiver (10, 10') in accordance with claim 1 or 2, wherein the filter unit (16) comprises two filter banks (16_1, 16_2) comprising at least one filter (16a, 16b, 16b-16l) each, wherein the at least two filters (16a, 16b, 16b-16l) of the two filter banks (16_1, 16_2) divide the frequency band to be digitalized into the at least two sub-bands (26a, 26b) such that the sub-bands (26a, 26b) of the at least two filters (16a, 16b, 16b-16l) of the two filter banks (16_1, 16_2) overlap partly.

4. The receiver (10, 10') in accordance with any of the preceding claims, wherein the filter unit (16) comprises a total number of at least three filters (16a, 16b, 16b-16l) for at least three receive paths (a, b, a-l) so that the frequency band to be digitalized is dividable into at least three sub-bands (26a, 26b) for the at least three receive paths (a, b, a-l).

5. The receiver (10, 10') in accordance with claim 4, wherein the at least three filters (16a, 16b, 16b-16l) comprise such a filter characteristic that the change in filter bandwidth thereof is equal with +/-30%, wherein the center frequency of the respective bandwidth increases over the at least three filters (16b, 16b-16l) of the filter bank.

6. The receiver (10, 10') in accordance with any of claims 3 to 5, wherein two filters (16a, 16, 16b-16l) in one of the two filter banks (16_1, 16_2) having directly successive center frequencies, with regard to the bandwidth, are configured such that the sub-bands (26a, 26b) of one of the two filter banks (16_1, 16_2) do not overlap, wherein a filter (16a, 16b, 16b-16l) of the other one of the two filter banks (16_1, 16_2), with regard to its center frequency, is located therebetween.

7. The receiver (10, 10') in accordance with any of the preceding claims, wherein the relative bandwidth is in a range from 1:1.4 to 1:1.6, and wherein the center frequency increases by a factor in the range from 1.2 to 1.4.

8. The receiver (10, 10') in accordance with any of the preceding claims, wherein the filter unit (16) comprises an additional low-pass filter which, when compared to the at least two filters (16b, 16b-16l), comprises the lowest center frequency.

9. The receiver (10, 10') in accordance with any of the preceding claims, wherein the at least two filters (16a, 16b, 16b-16l) of the filter unit (16) comprise exclusively passive elements.

10. The receiver (10, 10') in accordance with any of the preceding claims, wherein the at least two filters (16a, 16b, 16b-16l) of the filter unit (16) and/or the two filter banks (16_1, 16_2) are connected to the common signal source (12, 12a') via a common power divider (121').

11. The receiver (10, 10') in accordance with any of the preceding claims, wherein the at least two filters (16a, 16b, 16b-16l) of the filter unit (16) and/or the two filter banks (16_1, 16_2) are connected to a common antenna (12a') as a common signal source (12, 12a') or are connected to the common antenna (12a') via a common power divider (121').

12. The receiver (10, 10') in accordance with any of claims 2 to 11, wherein the number of filters (16a, 16, 16b-16l) of the filter unit (16) is selected such that the entire frequency band to be digitalized is covered by the sub-bands (26a, 26b).

13. The receiver (10, 10') in accordance with any of the preceding claims, wherein the digital signal processing comprises an FPGA.

14. The receiver (10, 10') in accordance with any of the preceding claims, wherein merging takes place in the digital signal processing (14) in a lossless way.

15. The receiver (10, 10') in accordance with any of the preceding claims, wherein each of the at least two signal paths between the analog-to-digital converter (18a, 18b, 18a-18l) and the respective filter (16a, 16b, 16b-16-l) comprises an automatic amplifier controller (15a-15l) and/or an amplifier (17a-17l).

16. A method for receiving an analog signal comprising a frequency band to be digitalized, comprising the steps of:
dividing the frequency band to be digitalized into at least two sub-bands (26a, 26b) by means of a filter unit (16) comprising at least two filters (16a, 16b, 16b-16l) for at least two receive paths (a, b, a-l), wherein the at least two filters (16a, 16b, 16b-161) are coupled to a common signal source (12, 12') in order to obtain the analog signal comprising the frequency band to be digitalized;
digitalizing, per receive path (a, b, a-l), the signals of the at least two sub-bands (26a, 26b) by means of an analog-to-digital converter (18, 18b, 18a-18l) per receive path (a, b, a-l); and
merging the at least two digitalized signals by means of digital signal processing (14) coupled to the at least two analog-to-digital converters (18a, 18b, 18a-18l) of the at least two receive paths (a, b, a-l) in order to obtain the at least two digitalized signals,
**characterized in that** the at least two filters (16a, 16b, 16b-16l), with regard to their filter characteristic, are implemented such that the sub-bands (26a, 26b) comprise a relative bandwidth of smaller than 1:2 with respect to each other so that the two filters (16a, 16b, 16b-16i) are implemented with a change in filter bandwidth relative to the bandwidth of a neighboring filter of the at least two filters (16a, 16b, 16b-161).

17. A computer program comprising program code for performing the method in accordance with claim 16 when the program runs on a computer.

## Revendications

1. Récepteur (10, 10') destiné à recevoir un signal analogique à bande de fréquences à numériser, aux caractéristiques suivantes:
une unité de filtres (16) avec au moins deux filtres (16a, 16b, 16b à 161) pour au moins deux voies de réception (a, b, a à 1) qui sont couplées à une source de signal commune (12, 12') pour obtenir le signal analogique à la bande de fréquences (22) à numériser, et qui est conçue pour diviser la bande de fréquences à numériser en au moins deux sous-bandes (26a, 26b) (26a, 26b) pour les au moins deux voies de réception (a, b, a à 1);
par voie de réception (a, b, a à 1), un convertisseur analogique-numérique (18a, 18b, 18a à 181) qui est configuré pour numériser les signaux des au moins deux sous-bandes (26a, 26b); et
un processeur de signal numérique (14) qui est couplé aux au moins deux convertisseurs analogique-numérique (18a, 18b, 18a à 181) des au moins deux voies de réception (a, b, a à 1) pour obtenir les au moins deux signaux numérisés, et qui est configuré pour assembler les au moins deux signaux numérisés;
**caractérisé par le fait que** les au moins deux filtres (16a, 16b, 16b à 161) sont conçus, en ce qui concerne leur caractéristique de filtre, de sorte que les au moins deux sous-bandes (26a, 26b) présentent une largeur de bande relative inférieure à 1:2 entre elles, de sorte que les deux filtres (16b, 16b à 16l) soient conçus avec une modification de la largeur de bande de filtre par rapport à la largeur de bande d'un filtre adjacent des au moins deux filtres (16a, 16b, 16b à 161).

2. Récepteur (10, 10') selon la revendication 1, dans lequel les au moins deux filtres (16a, 16b, 16b à 161) sont des filtres de sous-octave (16a, 16b, 16b à 161) et/ou présentent une caractéristique de filtre de sous-octave.

3. Récepteur (10, 10') selon la revendication 1 ou 2, dans lequel l'unité de filtres (16) comporte deux bancs de filtres (16_1, 16_2), chacun avec au moins un filtre (16a, 16b, 16b à 161), dans lequel les au moins deux filtres (16a, 16b, 16b à 161) des deux bancs de filtres (16_1, 16_2) divisent la bande de fréquences à numériser en les au moins deux sous-bandes (26a, 26b) de sorte que les sous-bandes (26a, 26b) des au moins deux filtres (16a, 16b, 16b à 161) des deux bancs de filtres (16_1, 16_2) se recouvrent partiellement.

4. Récepteur (10, 10') selon l'une des revendications précédentes, dans lequel l'unité de filtres (16) présente en tout au moins trois filtres (16a, 16b, 16b à 161) pour au moins trois voies de réception (a, b, a à 1), de sorte que la bande de fréquences à numériser puisse être divisée en au moins trois sous-bandes (26a, 26b) pour les au moins trois voies de réception (a, b, a à 1).

5. Récepteur (10, 10') selon la revendication 4, dans lequel les au moins trois filtres (16a, 16b, 16b à 161) présentent une caractéristique de filtre telle que leur variation de largeur de bande de filtre soit égale à +/- 30%, où la fréquence centrale de la largeur de bande respective augmente sur les au moins trois filtres (16b, 16b à 161) du banc de filtres.

6. Récepteur (10, 10') selon l'une des revendications 3 à 5, dans lequel deux filtres (16a, 16b, 16b à 161) dans l'un des deux bancs de filtres (16_1, 16_2) à fréquences centrales qui se suivent directement sont conçus, en ce qui concerne la largeur de bande, de sorte que les sous-bandes (26a, 26b) de l'un des deux bancs de filtres (16_1, 16_2) ne se recouvrent pas, où un filtre (16a, 16b, 16b à 161) de l'autre des deux bancs de filtres (16_1, 16_2) se situe, en ce qui concerne sa fréquence centrale, entre ces derniers.

7. Récepteur (10, 10') selon l'une des revendications précédentes, dans lequel la largeur de bande relative est de l'ordre de 1:1,4 à 1:1,6 et dans lequel la fréquence centrale augmente d'un facteur de l'ordre de 1,2 à 1,4.

8. Récepteur (10, 10') selon l'une des revendications précédentes, dans lequel l'unité de filtres (16) présente un filtre passe-bas additionnel qui, en comparaison avec les au moins deux filtres (16b, 16b à 161), comporte la fréquence centrale la plus basse.

9. Récepteur (10, 10') selon l'une des revendications précédentes, dans lequel les au moins deux filtres (16a, 16b, 16b à 16l) de l'unité de filtres (16) présentent exclusivement des éléments passifs.

10. Récepteur (10, 10') selon l'une des revendications précédentes, dans lequel les au moins deux filtres (16a, 16b, 16b à 161) de l'unité de filtres (16) et/ou les deux bancs de filtres (16_1, 16_2) sont connectés par l'intermédiaire d'un diviseur de puissance commun (12l') à la source de signal commune (12, 12a').

11. Récepteur (10, 10') selon l'une des revendications précédentes, dans lequel les au moins deux filtres (16a, 16b, 16b à 161) de l'unité de filtres (16) et/ou les deux bancs de filtres (16_1, 16_2) sont connectés à une antenne commune (12a') comme source de signal commune (12, 12a') ou sont connectés par l'intermédiaire d'un diviseur de puissance commun (12l') à l'antenne commune (12a').

12. Récepteur (10, 10') selon l'une des revendications 2 à 11, dans lequel le nombre des filtres (16a, 16b, 16b à 161) de l'unité de filtres (16) est choisi de sorte que par les sous-bandes (26a, 26b) soit couverte toute la bande de fréquences à numériser.

13. Récepteur (10, 10') selon l'une des revendications précédentes, dans lequel le traitement de signal numérique comporte un FPGA.

14. Récepteur (10, 10') selon l'une des revendications précédentes, dans lequel l'assemblage dans le traitement de signal numérique (14) s'effectue sans perte.

15. Récepteur (10, 10') selon l'une des revendications précédentes, dans lequel chacune des au moins deux voies de signal entre le convertisseur analogique-numérique (18a, 18b, 18a à 18l) et le filtre associé (16a, 16b, 16b à 161) présente une régulation automatique d'amplification (15a à 151) et/ou un amplificateur (17a à 17l).

16. Procédé de réception d'un signal analogique à bande de fréquences à numériser, aux étapes suivantes consistant à:
diviser la bande de fréquences à numériser en au moins deux sous-bandes (26a, 26b) au moyen d'une unité de filtres (16) avec au moins deux filtres (16a, 16b, 16b à 161) pour au moins deux voies de réception (a, b, a à l), où les au moins deux filtres (16a, 16b, 16b à 161) sont couplés à une source de signal commune (12, 12') pour obtenir le signal analogique à la bande de fréquences à numériser;
numériser par voie de réception (a, b, a à l) les signaux d'au moins deux sous-bandes (26a, 26b) au moyen d'un convertisseur analogique-numérique (18a, 18b, 18a à 18l) par voie de réception (a, b, a à 1); et
assembler les au moins deux signaux numérisés au moyen d'un processeur de signal numérique (14) qui est couplé aux au moins deux convertisseurs analogique-numérique (18a, 18b, 18a à 181) des au moins deux voies de réception (a, b, a à 1) pour obtenir les au moins deux signaux numérisés,
**caractérisé par le fait que** les au moins deux filtres (16a, 16b, 16b à 161) sont conçus, en ce qui concerne leur caractéristique de filtre, de sorte que les sous-bandes (26a, 26b) présentent une largeur de bande relative inférieure à 1:2 entre elles, de sorte que les deux filtres (16a, 16b, 16b à 161) soient conçus avec une variation de la largeur de bande de filtre par rapport à la largeur de bande d'un filtre adjacent des au moins deux filtres (16a, 16b, 16b à 161).

17. Programme d'ordinateur avec un code de programme pour mettre en oeuvre le procédé selon la revendication 16 lorsque le programme est exécuté sur un ordinateur.
